Europäisches Patentamt

European Patent Office

Office européen des brevets

(19)

(11) Publication number: **0 444 356 A2**

## (12) EUROPEAN PATENT APPLICATION

(21) Application number: **90314082.0**

(22) Date of filing: **20.12.90**

(51) Int. Cl.5: **C30B 31/00, C30B 31/14**

The title of the invention has been amended (Guidelines for Examination in the EPO, A-III, 7.3).

(30) Priority: **29.12.89 US 459050**

(43) Date of publication of application:
**04.09.91 Bulletin 91/36**

(84) Designated Contracting States:
**AT BE CH DE DK ES FR GB GR IT LI LU NL SE**

(71) Applicant: **THE CARBORUNDUM COMPANY**
**200 Public Square**
**Cleveland Ohio 44114-2375(US)**

(72) Inventor: **Dalcin, James R.**
**3480 Wallace Drive**
**Grand Island, New York 10494(US)**
Inventor: **Flemish, Joseph R.**
**529 Cumberland Street**
**Westfield, New Jersey 07090(US)**
Inventor: **Rogers, Michael C.**
**6699 Rapids Road**
**Lockport, New York 10494(US)**
Inventor: **Tressler, Richard E.**
**1040 Boalsburg Road**
**Boalsburg, Pennsylvania 16827(US)**
Inventor: **Tworek, John L.**
**31 East Bihrwood Drive**
**West Seneca, New York 14224(US)**
Inventor: **Viswanathan, Lakshminarayan**
**62 Bramhill Circle**
**East Amherst, New York 14051(US)**

(74) Representative: **Crack, Richard David et al**
**BP INTERNATIONAL LIMITED Patents**
**Division Chertsey Road**
**Sunbury-on-Thames Middlesex TW16**
**7LN(GB)**

(54) **Diffusion apparatus for semiconductors.**

(57) A method and apparatus for doping semiconductor wafer materials, where the apparatus includes a generally elongated tube (10) with means (26) for flowing gas into the tube, a heating means (30) surrounding the exterior of the tube (10) for heating wafers placed within the tube, a vacuum means (16) connected to the tube for evacuating gas from the tube (10), and an encapsulated boat means (40), which is generally cylindrically shaped, and includes a means (42) for holding wafers (50) within the boat in a spaced-apart mutually parallel arrangement with a dopant source for doping said wafers (50), and a means (44) which substantially encloses the dopant source (54) and wafers (50) and which is placed within the generally elongated tube (10).

FIG. 1

## DIFFUSION APPARATUS

BACKGROUND OF THE INVENTION

The present invention relates generally to diffusion systems and, in particular, to an apparatus which produces a more uniform doping of silicon wafers and extends the life of the dopant source material.

In the process of fabricating semiconductor devices it is often necessary to dope various impurity elements into substrates such as those made of a silicon semiconductor material by thermal diffusion methods by which impurities diffuse into the substrates, which will be referred to as "wafers". But, the semiconductor material could be in any of a variety of shapes and could be made from materials other than silicon.

The prior art apparatus for carrying out the diffusion process includes a diffusion furnace, having a heating means such as an electric coil heater, which is controlled with a high degree of accuracy to minimize temperature variation in the furnace, an evacuation means for evacuating air from the furnace, a gas flow means for flowing a gas or gases into the furnace to exclude oxygen and/or other gases which would interfere with the diffusion process, and a support means for supporting or holding the wafers and dopant source material in a regularly spaced, usually parallel, relationship, which support means are referred to in the industry as "boats". The plurality of wafers to be processed are placed in a predetermined position in the boat, with a dopant source which can be in a wafer form, placed between the semiconductor wafers. The boat is then placed in the furnace which is evacuated, heated and inert gas allowed to flow into the furnace. The flow of the inert gas over the wafers is designed such that it serves to seal out objectionable gases by forming a laminar layer over the wafers and dopant source. After being kept for the predetermined diffusion time, the boats are withdrawn from the furnace tube when the thermal diffusion of the wafers is completed.

The electrical characteristics of the semiconductor devices fabricated by the diffusion of impurity elements into semiconductor wafers are influenced by the concentration and the depth of penetration of impurities into the wafers, as well as the uniformity of the deposition. Further, because of the flowing gases during the diffusion process, the elements which are to be diffused into the semiconductor wafers, can be carried away in the gas stream and result in a limited utility of the source material.

It is an object of the present invention to provide a process and apparatus for thermal diffusion of semiconductor wafers, which provides a more uniform distribution of the doping elements and increases the usable life of the dopant source materials.

The present invention will become more apparent from the following description taken in conjunction with the accompanying drawings.

BRIEF DESCRIPTION OF THE DRAWINGS

Figure 1 is a side sectional view of an overall thermal diffusion apparatus in accordance with the present invention;

Figure 2 is a side cross sectional view of a closed boat system in accordance with the present invention;

Figure 3 is a perspective view of another embodiment of the closed boat system, and

Figure 4 is a sectional view taken along lines 44 in Figure 3.

Figure 5 is a graph of the standard Deviation of the sheet resistance of antimony doped wafer.

Figure 6 and 7 are graphs of the sheet resistance of an arsenic doped wafer versus the weight loss of the source wafer, with Figure 6 being from clam shell system and Figure 7 being regular boat.

Figure 8 is a graph similar to Figure 5, but for an arsenic doped wafer.

Figures 9 and 10 are graphs showing the effect of closed boat versus an open boat on the uniformity of doping using a phosphate doping source at 900° C and 950° C, respectively.

DESCRIPTION OF THE PREFERRED EMBODIMENTS

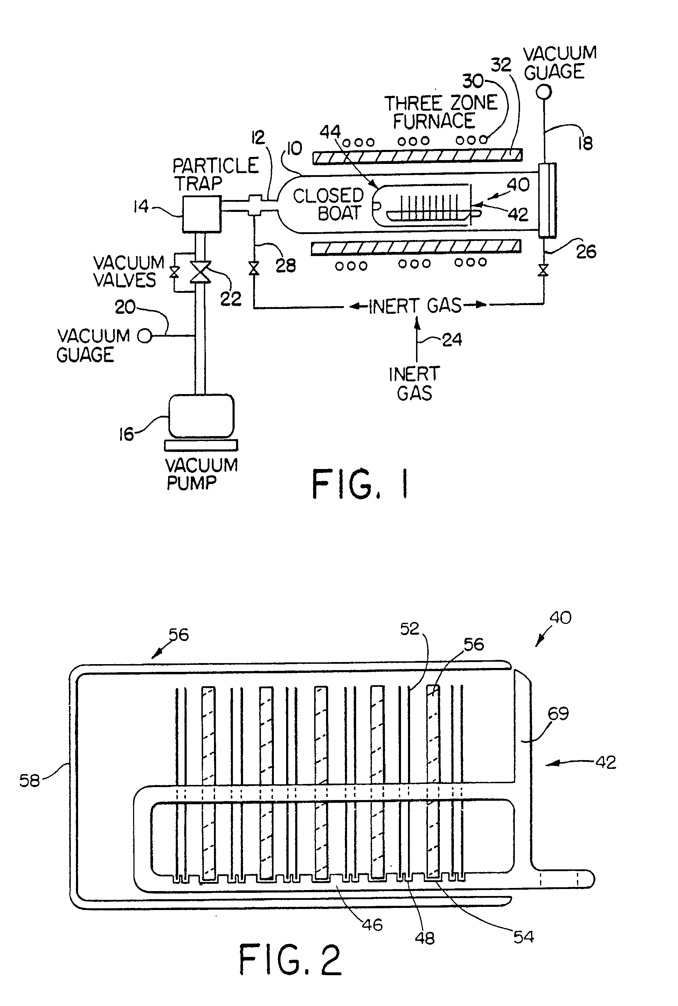

Figure 1 shows a diffusion apparatus generally which includes a quartz tube 10 having a gas outlet 12 through which the air in the tube 10 can be evacuated through a particle trap 14 connected to a vacuum pump 16. Appropriate vacuum gauges 18 and 20 are connected at the inlet and outlet lines to measure the vacuum in the system which can be controlled by a valve 22. Also, inert gas 24 can be introduced into the tube 10 by inlets 26 and/or 28 to control total pressure in diffusion tube 10. The feed of inert gas will serve to balance and control the pressure of the system, for example, by operating the inert gas feed in conjunction with a constant running of the vacuum pump 16.

Surrounding tube 10 is a resistance heating means which comprises electric coils 30 which can be energized by an energy source (not shown) to produce heat and heat diffusion tube 10 via furnace lining 32. Located within the furnace tube 10 is a boat system 40 which consists of a means 42 for holding the wafers and diffusion sources in spaced apart parallel relationship, i.e., the boat and a tube 42 made of a refractory material. Boat system 40 is best illustrated in Figure 2.

The furnace generally is considered to be conventional and would normally be operated with an open boat such as boat 42 without tube 44 which closes or encapsulates the boat 42. As will be explained further herein, it is the use of a closed boat which produces the beneficial results of more uniform doping and extended dopant source (or diffusion source) life.

Boat system 40 comprises a boat 42, which is made of, e.g., quartz, although other refractory materials could be used, comprises a bottom support 46 having slots 48 therein for supporting the semiconductor wafers 50 and slots 52 for supporting a dopant source material 54, and keeping them in appropriate, regular, spaced-apart relationship. Surrounding the boat is generally cylindrical shaped elongated tube 56 having one end 58 sealed and the other end open into which is inserted the boat 42 which has a generally cylindrical end plate 59 to make a closed boat. The degree of closure or seal is not considered critical so the matching of plate 59 and tube 56 is such that boat 42 can slide in and out of tube 56 and provide a loose closure.

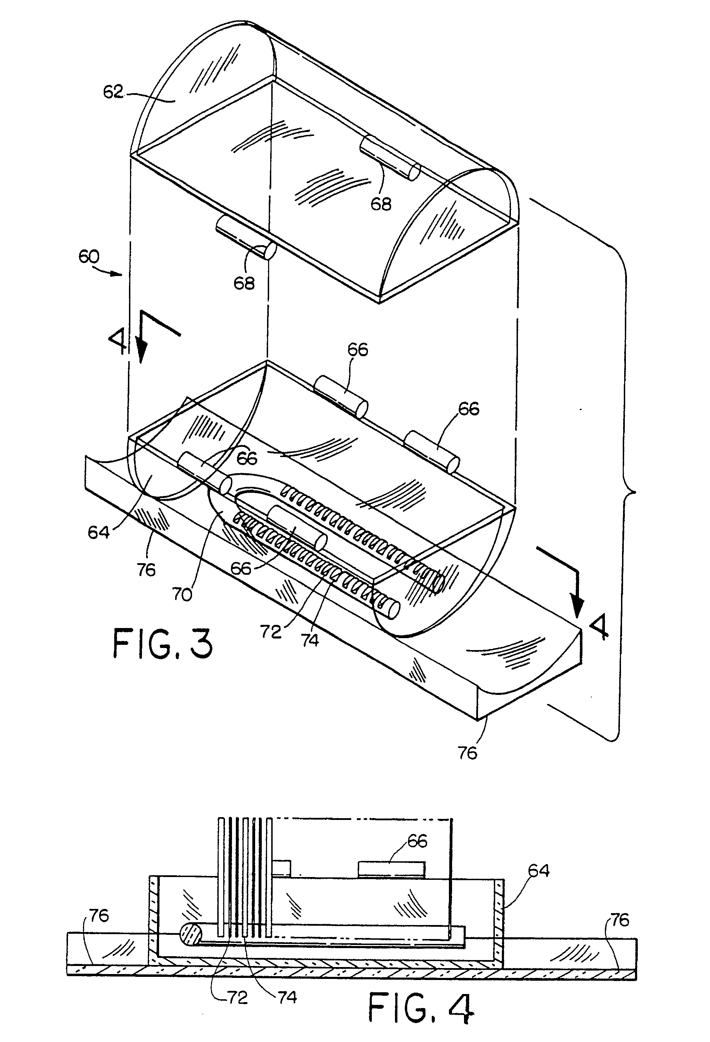

Figure 3 illustrates another embodiment of the closed boat system in which the boat system 60 comprises a top 62 and a bottom 64 each of which is best described as a split closed cylinder each of the halves fitting together to form a clam shell type of boat. The peripheral edges of the bottom 64 have cylindrical lobes 66 which are spaced apart enough to work in conjunction with lobes 68 on the top half 62 to guide the semicylindrical pieces together in operation. At the bottom of half 64 is a wafer support means 70 having slots 72 and 74 cut therein for holding the semiconductor wafers and dopant source material in appropriate, regular, spaced-apart relationship. Support legs 76 serve to support the boat and keep it in position.

In order to demonstrate the present invention, silicon wafers were doped with phosphorous, antimony or arsenic using commercially available phosphorous and arsenic solid planar diffusion sources. Boron solid planar diffusion sources, made from boron nitride (BN) powder are commercially available and are considered useful with the present invention, although they were not tested. The phosphorous source consisted primarily of micron sized silicon pyrophosphate powder ($SiP_2O_7$) impregnated and sintered on a porous siliconized-silicon carbide, 3" diameter support wafer. The arsenic source consisted of a powder mixture of 27 weight percent aluminum arsenate ($AlAsO_4$), 63 weight percent yttrium arsenate ($YAsO_4$), and 10 weight percent silica ($SiO_2$), being approximately 1 micron (Mn) particle size, which was impregnated and sintered on a porous siliconized-silicon carbide support wafer, which was 3 inches in diameter. The antimony diffusion source was made in the laboratory in a similar manner as the commercially available phosphorous or arsenic sources and was formed using antimony silicate powder ($SbSiO_x$) which is made by reacting antimony trioxide ($Sb_2O_3$) with silica ($SiO_2$), such as is taught in U.S. Patent No. 4,749,615 to A.M. Bonny et al, the teachings of which are incorporated herein by reference. Another source could be aluminum antimoniate ($AlSbO_4$) or the like antimony source material. Other arsenate dopant sources could be used such as are disclosed in U.S. Patent No. 4,798,764 to Tressler et al., the teachings of which are incorporated herein by reference, and other phosphorous sources disclosed in U.S. Patent Numbers 3,852,086, to Y. Murata et al; and 3,954,525 to T.A. Myles et al, the teachings of which are also incorporated herein by reference.

The silicon wafers in all experiments were 3 inch diameter, p-type (boron doped), with a resistivity range of 10 to 20 ohm/cm. Prior to the phosphorous and arsenic diffusion experiments, the silicon wafers were cleaned using the cleaning steps set forth as follows:

1. Immerse the wafers in an aqueous ammonia and peroxide solution ($H_2O:H_2O_2:NH_4OH$ in ratio 5:1:1) for 5 minutes at $80^\circ$ C to remove organic contaminants.

2. Rinse the wafers in deionized water 5 minutes.

3. Immerse the wafers in an aqueous hydrochloric acid and peroxide solution ($H_2O:H_2O_2:HC1$ in ratio 6:1:1) for 5 minutes at $80^\circ$ C to remove metallic impurities.

4. Rinse the wafers in deionized water 5 minutes.

5. Dip the wafers in hydrogen fluoride (HF) (10% solution) 15 seconds to further clean the wafer by etching the thin silicon surface layer which has been oxidized by the hot peroxide solutions.

6. Rinse the wafers in deionized water 10 minutes.

7. Spin dry the wafers.

All chemicals used were MOS High Purity Grade Meeting ASTM specifications.

The diffusion system shown in Figure 1 was employed to control total pressure, ambient gas flow rate, and temperature. A 101 mm, inside diameter, fused silica furnace tube was fitted into a 3-zone, resistance heated furnace made by Corso Gray, having a stainless steel door, o-ring sealed, low pressure load-door with gas inlet ports, and modified with Thermco Black Max heating elements. The furnace had at the back end of the silica tube, a stainless steel manifold leading to a two-stage mechanical vacuum pump with a pumping capacity of 14 ft$^3$/min.

The total pressure of the system was controlled independently of the ambient flow by bleeding nitrogen downstream at the pump inlet. The total pressure was measured at the front of the tube by the load-door, and at the back by the pump inlet using calibrated thermal conductivity type vacuum gauges.

For the diffusion experiments, the silicon and source wafers were placed face to face in a slotted, silica wafer boat, spaced approximately 0.060" apart as shown in Figure 2. Two types of wafer boats, "open" and "closed", were used. Figures 1 and 2 show one embodiment of a closed boat, while Figures 3 and 4 show another embodiment, which can be referred to as a "clam shell" boat. As noted earlier, by not using, e.g., generally cylindrical shaped elongated tube 44, shown in Figure 2, the boat 42 would constitute and open the boat. The open wafer boat, commonly used in a diffusion process, allows the edges of the wafers to be exposed to the flowing ambient gas.

After loading, i.e., placing the silicon and source wafers in the boat, the wafer boat was admitted into the cool front end of the furnace tube, while the tube was purged from back to front with nitrogen at a flow of 10 standard liters per minute. If the open boat configuration was used, purging continued for 10 minutes prior to pushing the boat into the furnace hot-zone. If the closed boat was used, the furnace was evacuated to 0.5 torr and backfilled prior to pushing the wafer boat into the hot-zone. In the case of arsenic diffusion, a foil baffle (not shown) with a pull-rod hole was used during purging and loading, in order to prevent trace amounts of $O_2$ from being admitted into the system.

The process gas was nitrogen from a liquid source. The $N_2$ was gettered of oxygen by passing through Cu shavings at 250°C. Oxygen levels in the process gas were measured with a zirconia-type sensor and were found to be approximately 10 ppm $O_2$. Oxygen levels measured in the furnace effluent were found to be as high as 100 ppm immediately after wafer loading operations. Diffusions processes were performed at temperatures ranging from 850 to 1025°C, and at total pressures of 0.5, 5, and 50 torr, as well atmospheric pressure. After processing, the silicon sheet resistance was measured using a collinear four-point probe made by Probex, and in accordance with ASTM specification F84-84(a). In this method four probes equally spaced by 0.040" are placed in contact with the silicon wafer. A constant current is passed through the outer two probes and the resulting potential difference is measured between the inner probes.

After 60 minutes in the diffusion furnace, the boat was removed from the furnace and held in a cooling area until the samples had achieved room temperature, which was about 70°F. The antimony diffusion sources were measured to determine the weight loss over time and the sheet resistance, which is reported as an average of the upstream and downstream sheet resistance. The results clearly show that the silicon wafers doped in a closed boat (in this case the clam shell boat) last longer than those used in a furnace without a closed boat.

<table>
<tr><td colspan="5">

**TABLE I**

**ANTIMONY DIFFUSION SOURCE**

</td></tr>
</table>

| Hour | Weight Loss (grams) Open Boat | Closed Boat | Sheet Resistance (Ohms per square) Open Boat | Closed Boat |
|---|---|---|---|---|
| 0 | | | | |
| 1 | 0.968 grams | 0.741 grams | | |
| 2 | 1.023 | 0.119 | 27.25 ohm/sq | 27.9 ohm/sq |
| 3 | 1.125 | 0.413 | 29.45 | 28.8 |
| 4 | 0.843 | 0.658 | 84 | 43.3 |
| 5 | 0.213 | 0.523 | 1001.85 | 28.8 |
| 6 | 0.17 | 0.427 | 715.75 | 51.2 |
| 7 | | 0.171 | | 23.8 |
| 8 | | 0.046 | | 33.4 |
| 9 | | 0.019 | | 91.3 |
| 10 | | 0.011 | | 168.3 · |

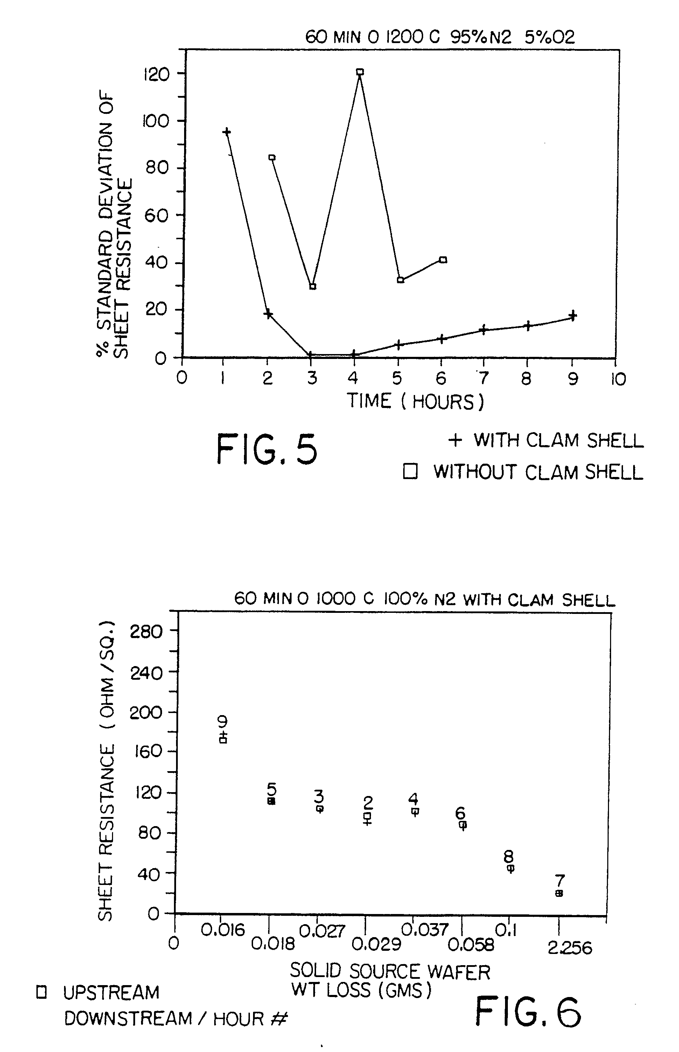

As shown in Figure 5, plots of the standard deviation of the sheet resistance for wafers doped in a closed boat, e.g., a clam shell boat, versus a regular boat, or prior art system i.e., without a clam shell, indicates that the closed boat system quickly performs more uniformly than does the prior art system.

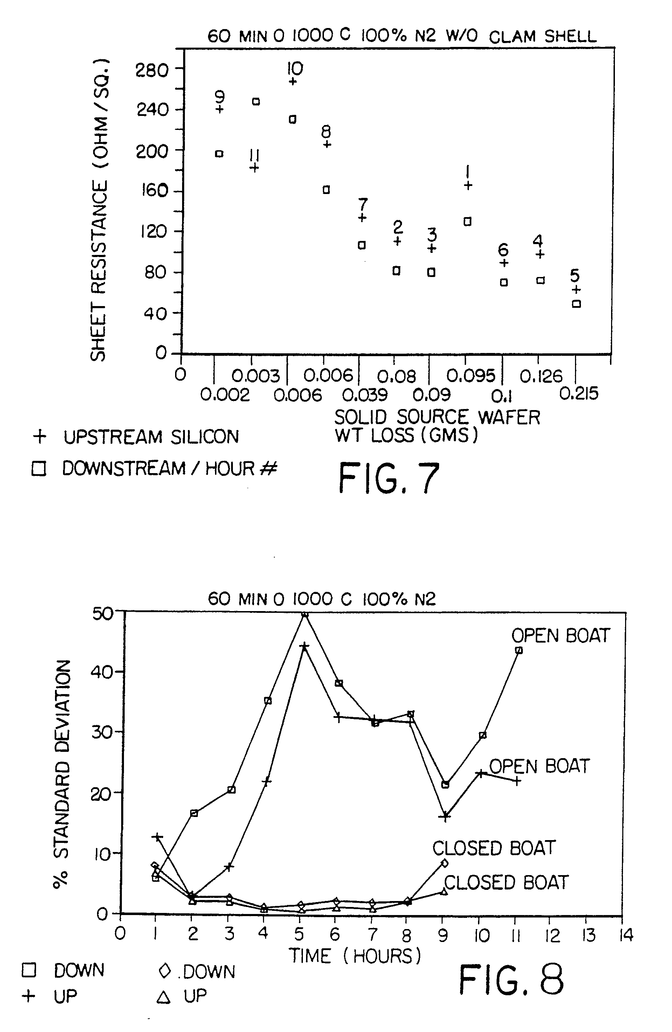

A similar doping test was run using an arsenic source and the same doping steps and conditions. The results are shown in Figures 6, 7 and 8 with Figures 6 and 7 being a comparison of closed boat (Fig. 6) vs. open boat (Fig. 7). These results show that the closed boat process is much more uniform in doping the silicon wafers.

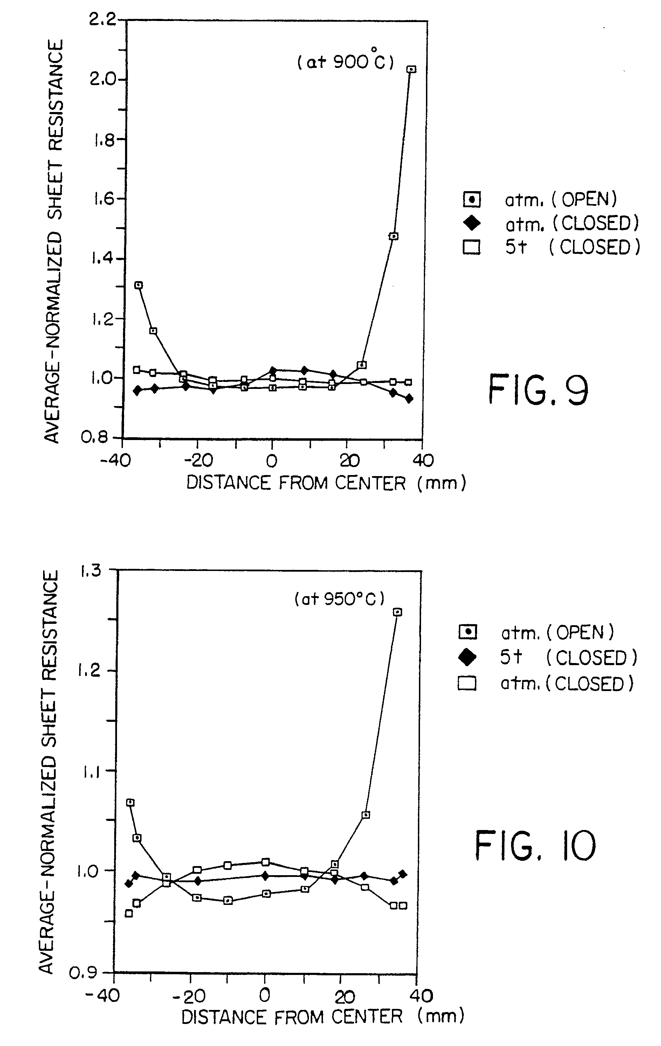

The results shown in Figures 9 and 10 are plots of the average-normalized sheet resistance versus distance from center in millimeters using a phosphorous diffusion source ($SiP_2O_7$) at two temperatures, namely 900°C and 950°C. These results show that the closed boat system (closed) provides greater doping uniformity under atmospheric or vacuum (5 torr) conditions than does the open boat system (open).

The invention has been described with respect to certain preferred embodiments. Various modifications and additions within the spirit of the invention will occur to or be made by those skilled in the art without departing from the concept of the invention. Therefore, the scope of the invention is to be determined by reference to the following claims.

**Claims**

1. In an apparatus for doping semiconductor wafer materials, the apparatus being of the type having a generally elongated tube with means for flowing gas into the tube, a heating means surrounding the exterior of the tube for heating wafers placed within the tube, and a vacuum means connected to the tube for evacuating gas from the tube, the improvement comprising:
   an encapsulated boat means, which boat means is placed within the generally elongated tube, said boat means being generally cylindrically shaped, and including means for holding the wafers within the boat in a spaced-apart mutually parallel arrangement and means for holding the dopant source means for doping said wafers, said boat means being capable of substantially enclosing said dopant source and semiconductor material.

2. The apparatus as claimed in claim 1 wherein said vacuum means is able to reduce the pressure in the tube to 5 to 50 torr.

3. The apparatus as claimed in claim 1 or 2 wherein said boat means comprises a generally cylindrical tube having a one end sealed and the opposite end closed by a removable cover.

4. The apparatus as claimed in any one of claims 1 to 3 wherein said boat comprises a hollow, closed cylinder which separates along its length to open.

5. The apparatus as claimed in any one of claims 1 to 4 wherein said boat means comprises a generally cylindrical tube having an open end and said means for holding said wafers is integral with a removable cover for substantially closing said open end.

6. The apparaus as claimed in claim 4 in which said boat is in the form of a clam shell.

7. The apparatus as claimed in any one of claism 1 to 6 whioh further includes a dopant source means selected from the group comprising boron, phosphorous, arsenic and antimony.

8. The apparatus as claimed in claim 7 wherein said dopant source means is selected from the group comprising arsenic and antimony.

9. The apparatus as claimed in any one of claims 1 to 8 wherein said enclosed boat means further has gas inlet means and gas outlet mean for flowing a gas into and out of said enclosed boat means.

10. The apparatus as claimed in any one of the preceding claims wherein said elongated tube is quartz.

11. The apparatus as claimed in any one of the preceding claims wherein said encapsulated boat means is made of refractory material.

12. The apparatus as claimed in claim 11 wherein said encapsulated boat means is made from a material selected from the group consisting of quartz, silicon carbide and polycrystalline silicon.

13. The apparatus as claimed in any one of claims 1 to 12 wherein said elongated tube is oriented horizontally.

14. The apparatus as claimed in any one of claims 1 to 12 wherein said elongated tube is oriented vertically.

15. The apparatus as claimed in any one of claims 1 to 6 which further includes a dopant source means and semiconductor wafers and wherein said dopant source means is placed between said semiconductor wafers.

16. The apparatus as claimed in claim 15 wherein said dopant source means is a planar diffusion source.

17. The apparatus as claimed in claim 15 or 16 wherein said dopant source means is a coating on the inside of said encapsulated boat means.

18. The appartus as claimed in claim 15, 16 or 17 wherein said dopant source means is a powder.

19. In a method of doping semiconductor wafer materials wherein said wafer materials are placed in spaced-apart, mutually parallel arrangement with a dopant source, within an elongted quartz tube, said tube is evacuated, then an inert gas is flowed into and out of said tube, and said tube is heated, whereby said wafers will become doped, the improvement comprising placing said wafers and dopant in a substantially enclosed boat means to thereby produce a more uniformly doped wafer and prolong the resusable life of said dopant.

FIG. 1

FIG. 2

8

FIG. 3

FIG. 4

FIG. 5

60 MIN O 1200 C 95%N2 5%O2

+ WITH CLAM SHELL
□ WITHOUT CLAM SHELL

FIG. 6

60 MIN O 1000 C 100% N2 WITH CLAM SHELL

□ UPSTREAM
DOWNSTREAM / HOUR #

**60 MIN O 1000 C 100% N2 W/O CLAM SHELL**

+ UPSTREAM SILICON

□ DOWNSTREAM / HOUR #

**FIG. 7**

**60 MIN O 1000 C 100% N2**

□ DOWN    ◇ .DOWN
+ UP      △ UP

**FIG. 8**

FIG. 9

FIG. 10